# EUROPÄISCHE PATENTSCHRIFT

(11) **EP 0 703 623 B1**
(45) Veröffentlichungstag und Bekanntmachung des Hinweises auf die Patenterteilung: **23.06.1999**
(21) Anmeldenummer: 95113414.7
(22) Anmeldetag: 26.08.1995
(51) Int. Cl.: H01L 27/06, H01L 21/822

(54) **Verfahren zur Herstellung einer vertikalen integrierten Schaltungsstruktur**
Method of fabrication of a vertical integrated circuit structure
Procédé de fabrication d'une structure de circuit intégré verticale

(30) Priorität: 22.09.1994 DE 4433846
(43) Veröffentlichungstag der Anmeldung: 27.03.1996
(73) Patentinhaber: FRAUNHOFER-GESELLSCHAFT ZUR FÖRDERUNG DER ANGEWANDTEN FORSCHUNG E.V., 80636 München (DE)
(72) Erfinder: Ramm, Peter, Dr., D-85276 Pfaffenhofen (DE); Buchner, Reinhold, Dipl.-Phys., D-85774 Unterföhrung (DE)

(56) Entgegenhaltungen:
- SYMPOSIUM ON VLSI TECHNOLOGY, HONOLULU, JUNE 4 - 7, 1990, Nr. SYMP. 10, 4.Juni 1990 INSTITUTE OF ELECTRICAL AND ELECTRONICS ENGINEERS, Seiten 95-96, XP 000164428 HAYASHI Y ET AL 'FABRICATION OF THREE-DIMENSIONAL IC USING "CUMULATIVELY BONDED IC" (CUBIC) TECHNOLOGY'
- PATENT ABSTRACTS OF JAPAN vol. 013 no. 201 (E-757) ,12.Mai 1989 & JP-A-01 023564 (SHARP CORP) 26.Januar 1989,

## Beschreibung

Die Erfindung betrifft ein Verfahren zur Herstellung einer vertikalen integrierten Schaltungsstruktur. Vertikale Schaltungsstrukturen spielen bei der dreidimensionalen Integration eine wichtige Rolle. Unter dreidimensionaler Integration versteht man die vertikale Verbindung von Bauelementen, die mittels Planartechnik hergestellt wurden. Die Vorteile eines dreidimensional integrierten mikroelektronischen Systems sind u.a. die bei gleichen Designregeln erreichbaren höheren Packungsdichten und Schaltgeschwindigkeiten gegenüber zweidimensionalen Systemen. Letzteres ist zum einen bedingt durch kürzere Leitungswege zwischen den einzelnen Bauelementen oder Schaltungen, zum anderen durch die Möglichkeit der parallelen Informationsverarbeitung. Die Steigerung der Leistungsfähigkeit des Systems ist bei Realisierung einer Verbindungstechnik mit örtlich frei wählbaren höchstintegrierbaren vertikalen Kontakten optimal.

Zur Herstellung dreidimensionaler Schaltungsanordnungen mit frei wählbaren vertikalen Kontakten sind folgende Verfahren bekannt:

Y. Akasaka, Proc. IEEE 74 (1986) 1703, schlägt vor, auf eine fertig prozessierte Bauelementeschicht polykristallines Silizium abzuscheiden und zu rekristallisieren, so daß in der rekristallisierten Schicht weitere Bauelemente gefertigt werden können. Nachteile dieser Methode sind die ausbeutereduzierende Degradation der Bauelemente in der unteren Ebene durch die hohe thermische Belastung beim Rekristallisierungsprozeß, sowie die notwendigerweise serielle Prozessierung des Gesamtsystems. Letzteres bedingt zum einen entsprechend lange Durchlaufzeiten bei der Fertigung und hat zum anderen eine Ausbeuteminderung durch Aufsummierung der prozeßbedingten Ausfälle zur Folge. Beides erhöht die Fertigungskosten beträchtlich gegenüber einer Prozessierung der einzelnen Ebenen getrennt voneinander in verschiedenen Substraten.

Aus Y. Hayashi et al., Proc. 8th Int. Workshop on Future Electron Devices, 1990, p. 85, ist es bekannt, zunächst die einzelnen Bauelementeebenen getrennt voneinander in verschiedenen Substraten herzustellen. Anschließend werden die Substrate auf wenige Mikrometer gedünnt, mit Vorder- und Rückseitenkontakten versehen und mittels eines Bondverfahrens vertikal verbunden. Für die Bereitstellung der Vorder- und Rückseitenkontakte sind jedoch Sonderprozesse notwendig, die in der Standard - Halbleiterfertigung (CMOS) nicht vorgesehen sind, nämlich MOS - inkompatible Materialien (z.B. Gold) und Rückseitenstrukturierung des Substrates.

Die JP 63-213943 beschreibt ein Verfahren zur Herstellung einer vertikalen integrierten Schaltungsstruktur, bei dem die einzelnen Bauelementeebenen ebenfalls getrennt voneinander in verschiedenen Substraten hergestellt werden. Das obere Substrat wird mit Vialöchern versehen, die sämtliche Lagen mit Schaltungsstrukturen durchdringen. In der gleichen Weise wird das untere Substrat mit Kontaktlöchern versehen, die bis zur Metallisierungsebene dieses Substrates reichen. Nach dem rückseitigen Dünnen des oberen Substrates bis an die Vialöcher werden die beiden Substrate so zusammengefügt, daß die Vialöcher des oberen Substrates über den Kontaktlöchern des unteren Substrates liegen, so daß eine leitfähige Verbindung zwischen den Bauelementeebenen beider Substrate hergestellt werden kann.
Dieses Verfahren hat jedoch den Nachteil, daß bei beiden Substraten größere Vorhalte beim Design vorgesehen werden müssen, da sich die Vialöcher (Inter-Chip-Vias) bei der gegenseitigen Justage der Substrate aufeinander nicht nur innerhalb der Begrenzungen der Metallstrukturen des unteren Substrates sondern auch innerhalb der Begrenzungen der Kontaktlochöffnungen befinden müssen. Die Folge davon ist eine geringere mögliche Integrationsdichte.

Bei der Verbindung zweier fertig prozessierter Bauelementesubstrate ist eine genaue Justage der beiden Substrate über Justiermarken vor dem Zusammenfügen erforderlich. Soll eine Rückseitenstrukturierung vermieden werden, so werden die Justiermarken bisher im Bereich der Vorderseite der Substate aufgebracht und die Justage erfolgt im infraroten Durchlichtverfahren (bekannt z.B. vom sog. Flip-Chip-Bonden). Die zum Zeitpunkt des Zusammenfügens vorliegende Schichtfolge des oberen Substrats schließt eine optische Durchlichtjustierung der Bauelementeebenen zueinander im sichtbaren Spektralbereich aus.
Die Anwendung des infraroten Durchlichtverfahrens bedingt jedoch eine in der Halbleiterfertigung unübliche Spezialausrüstung, d.h. ein Bondgerät mit integrierter Infrarotdurchlichtjustierung. Die zu justierenden Substrate müssen zudem ausschließlich polierte Oberflächen aufweisen (Handling-Substrat und unteres Bauelementesubstrat), da sonst das Infrarotlicht an den Grenzflächen diffus gestreut wird und somit die Justiermarken nicht abgebildet werden können. Die Justiergenauigkeit ist selbst bei Verwendung von polierten Oberflächen aufgrund der größeren Wellenlänge des Infrarotlichtes im Vergleich zu sichtbarem Licht um etwa einen Faktor zwei kleiner als bei Justierung im sichtbaren Spektralbereich, so daß die Packungsdichte der vertikalen Verbindung nur ca. 25% des mit sichtbarem Licht erreichbaren Wertes beträgt. Darüber hinaus bewirkt der komplexe Schichtaufbau einer Integrierten Schaltung mit einer Vielzahl von Grenzflächen und den damit verbundenen Reflexionen eine weitere Verringerung der Justiergenauigkeit beim Durchlichtverfahren. Weiterhin bewirkt dieses Verfahren eine Einschränkung der Designfreiheit und der Substratauswahl, da in den Bereichen der Justiermarken eine gute Strahlungstransmission erforderlich ist.

Die Nachteile der genannten Verfahren bestehen also insbesondere in hohen Durchlaufzeiten der Substrate bei der Fertigung, der notwendigen Anwendung nicht CMOS-kompatibler Sonderprozesse, hohen Fertigungskosten, Ausbeuteminderung und/oder verminderter Integrationsdichte.

Der vorliegenden Erfindung liegt die Aufgabe zugrunde, ein CMOS-kompatibles Verfahren zur Herstellung einer vertikalen integrierten Schaltungsstruktur mit frei wählbaren vertikalen Kontakten anzugeben, das eine hohe Integrationsdichte und hohe Ausbeute ermöglicht.

Diese Aufgabe wird erfindungsgemäß mit dem Verfahren nach Anspruch 1 gelöst. Besondere Ausgestaltungen des Verfahrens sind Gegenstand der Unteransprüche.

Beim erfindungsgemäßen Verfahren werden die einzelnen Bauelementelagen in unterschiedlichen Substraten unabhängig voneinander prozessiert und nachfolgend zusammengefügt. Zunächst wird auf das fertigprozessierte Substrat (erstes Substrat; im folgenden als Topsubstrat bezeichnet) mit einem oder mehreren Bauelementelagen und Metallisierungsebenen, dessen Bauelementelagen in der fertigen intergrierten Schaltungsstruktur oberhalb der Bauelementelagen eines weiteren Substrates (zweites Substrat; im folgenden als Bottomsubstrat bezeichnet) liegen sollen, vorderseitig eine Maske (sog. hardmask) für späteres Ätzen (z.B. Trockenätzen) von dielektrischen Schichten (z.B. Oxid- und/oder Nitridschichten) aufgebracht. Die Maske kann beispielsweise eine Schicht aus TiN sein oder auch mit einem Si-Sputterprozeß erzeugt werden.
Das Topsubstrat wird anschließend an den Stellen vorderseitig mit Vialöchern versehen (z.B. durch Ätzen), an denen später ein vertikaler Kontakt zu den darunterliegenden Bauelementelagen des Bottomsubstrates erzeugt werden soll. Die Vialöcher sollten alle im Topsubstrat vorhandenen Bauelementelagen und Metallisierungsebenen durchdringen. Die Vialöcher enden vorzugsweise einige Mikrometer unterhalb der Bauelementelagen des Topsubstrates (Anspruch 5), bei Verwendung eines SOI-Substrates vorzugsweise an der vergrabenen Oxidschicht (Anspruch 6). Nach dem Prozessieren der Vialöcher wird auf die Vorderseite des Topsubstrates, z.B. über eine Haftschicht (Anspruch 9), ein Hilfssubstrat (Handlingsubstrat) aufgebracht. Anschließend wird das Topsubstrat von der Rückseite her gedünnt. Das Dünnen kann beispielsweise durch naßchemisches Ätzen oder durch mechanisches oder chemomechanisches Schleifen erfolgen (Anspruch 7). Bei Verwendung eines SOI-Substrates kann hierbei das vergrabene Oxid als Ätzstopp dienen (Anspruch 6). Bei Verwendung eines herkömmlichen Substrates (aus sog. Bulk-Material) kann das Dünnen bis an die Vialöcher erfolgen (Anspruch 5), so daß diese danach nach beiden Seiten des Substrates geöffnet sind.
Anschließend wird ein weiteres fertigprozessiertes Substrat mit einem oder mehreren Bauelementelagen und Metallisierungsebenen, das Bottomsubstrat, mit dem Topsubstrat verbunden. Hierzu wird vorzugsweise gemäß Anspruch 8 die Vorderseite des Bottomsubstrates, d.h. die Oberfläche der obersten Bauelementelage des Bottomsubstrates, mit einer transparenten Haftschicht versehen. Die Haftschicht kann gleichzeitig eine passivierende und/oder planarisierende Funktion übernehmen (Anspruch 10). Dann werden Topsubstrat und Bottomsubstrat aufeinander justiert und die Rückseite des Topsubstrates mit der Vorderseite des Bottomsubsrates verbunden. Die Justage kann dabei mit Hilfe einer Splitoptik anhand von Justiermarken im sichtbaren Spektralbereich erfolgen (Anspruch 2). Die Justiermarken werden hierbei im Topsubstrat analog zu den Vialöchern, d.h. vorzugsweise durch Ätzung von Justierstrukturen von der Vorderseite durch sämtliche Bauelementelagen des Topsubstrates, hergestellt, die Justiermarken des Bottomsubstrates können in der obersten Metallisierungsebene des Bottomsubstrates enthalten sein.
Nach dem Zusammenfügen des Top- und des Bottomsubstrates wird das Handlingsubstrat entfernt. Die bereits vorhandenen Vialöcher werden nun von der Vorderseite des Topsubstrates durch die verbleibenden Schichten (z.B. Oxidschicht des SOI-Topsubstrates, Haftschicht, Passivierungsschicht des Bottomsubstrates) bis auf die Metallisierungsschicht einer Metallisierungsebene des Bottomsubstrates verlängert (z.B. durch Trockenätzen), wobei die Maske (hardmask) des Topsubstrates als Ätzmaske dient.
Über diese Vialöcher wird schließlich der elektrische Kontakt zwischen der Metallisierung einer Metallisierungsebene des Top- und der Metallisierung einer Metallisierungsebene des Bottomsubstrates hergestellt.

Hierzu werden vorzugsweise gemäß Anspruch 11 zunächst die Seitenwände der Vialöcher isoliert und Kontaktlöcher zur Metallisierungsebene des Topsubstrates geöffnet. Anschließend wird auf der Oberfläche des Topsubstrates und in die Via- und Kontaktlöcher metallisches Material abgeschieden. Nach der Strukturierung dieser Verbindungsmetallisierung ist die vertikale Integration der Bauelementelagen von Top- und Bottomsubstrat hergestellt.

Aufgrund der Prozessierung einzelner Bauelementelagen getrennt voneinander in unterschiedlichen Substraten (parallele Prozessierung) ergibt sich mit dem erfindungsgemäßen Verfahren eine deutliche Verringerung der Durchlaufzeiten bei der Fertigung der vertikalen Schaltungsstruktur und somit eine Senkung der Fertigungskosten.
Beim erfindungsgemäßen Verfahren werden vorteilhafterweise nur CMOS-kompatible Technologien eingesetzt, da insbesondere auf eine Rückseitenstrukturierung der Substrate verzichtet werden kann.
Die Fertigung der Vialöcher noch am einzelnen Substrat (d.h. auf Scheibenebene) ermöglicht die Einbeziehung dieses Verfahrensschrittes in die Prozessierung des einzelnen Substrates (parallele Prozessierung) und führt daher insbesondere bei der Herstellung von Strukturen mit vielen Bauelementelagen, d.h. mit vielen mit dem erfindungsgemäßen Verfahren übereinanderzustapelnden Substraten, in vorteilhafter Weise zu einer weiteren Reduzierung der Durchlaufzeiten und zu einer Ausbeutesteigerung.

Das Aufbringen der Maskierungsschicht (hardmask) auf das Topsubstrat bei Beginn des Prozesses und das Verbleiben dieser Maske bis zum Öffnen der Vialöcher ermöglicht das Ätzen von Oxid- oder Nitridschichten, wie sie für die Passivierung, Planarisierung und Mehrlagenmetallisierung eingesetzt werden, zu jedem späteren Zeitpunkt des Fertigungsprozesses (der Stapelung). Das Öffnen von Kontaktlöchern im Bottomwafer bereits vor dem Zusammenfügen der Substrate ist somit nicht mehr notwendig. Die Inter-Chip-Vias müssen bei der Justierung lediglich innerhalb der Metallstrukturen des Bottomwafers liegen, so daß die notwendigen Vorhalte beim Design geringer ausfallen und somit eine höhere Integrationsdichte erreicht werden kann (Analogie zum Standardverfahren bei der Mehrlagenmetallisierung).
Des weiteren kann eine Planarisierung des Bottomwafers mit Oxidschichten vor dem Zusammenfügen durchgeführt werden, da die Oxidschichten später über die Maske des Topsubstrates geöffnet werden können. Das Entstehen von Lunkern beim Aufeinanderkleben wird dadurch erheblich vermindert und die Zuverlässigkeit der dreidimensionalen Schaltungsstruktur erhöht.
Ein weiterer Vorteil des Verfahrens ist der mögliche Einsatz von SOI-Substraten als Topsubstrate, da die vergrabene Oxidschicht nach dem Stapeln ebenfalls problemlos geätzt werden kann. Somit können die Vorteile des SOI-Materials (z.B. die Oxidschicht als Ätzstopp beim Dünnen des Topwafers, die große Planarität der Rückseite beim Aufeinanderkleben, kein Angriff der Vialöcher durch die Ätzlösung oder die CMP (Chemical Mechanical Polishing) beim Dünnen) ausgenutzt werden.
Die vertikalen Kontakte sind zudem aufgrund der Ätzmöglichkeit über die Maske des Topsubstrates bis zu beliebigen Metallisierungsebenen des Bottomwafers oder Bottomstapels realisierbar. Damit ist ein Zugriff auf beliebige Metallisierungsebenen des Stapels möglich, so daß eine große Gestaltungsfreiheit bei der Integration gegeben ist.

Ein weiterer Vorteil des Verfahrens besteht darin, daß zur Justage der einzelnen Bauelementelagen übereinander eine Split-Optik im sichtbaren Spektralbereich eingesetzt werden kann. Daher müssen im Gegensatz zu Durchlichtverfahren weder die Schichtfolge oberhalb der Justiermarken im Topsubstrat noch die Schichtfolge unterhalb der Justiermarken im Bottomsubstrat transparent sein.
Eine höhere Justiergenauigkeit und somit eine höhere Packungsdichte sind damit im Vergleich zu Infrarotdurchlichtverfahren erreichbar.

Das erfindungsgemäße Verfahren wird im folgenden anhand eines Ausführungsbeispiels und der Zeichnungen näher erläutert.

Dabei zeigen:
- Figur 1: beispielhaft den Verfahrensablauf des erfindungsgemäßen Verfahrens anhand der Strukturen eines Top- und eines Bottomsubstrates nach unterschiedlichen Verfahrensschritten; hierzu:
Figur 1a das Topsubstrat mit Passivierung der Oberfläche;
Figur 1b das Topsubstrat nach
- TiN-Deposition,
- Plasmaoxid-Deposition,
- Fototechnik "Trench",
- Oxid-Ätzen,
- TiN-Ätzen,
- Oxid-Ätzen,
- Lackentfernen und
- Trench-Ätzen (Ätzstopp: SiO₂);

Figur 1c das Topsubstrat nach
- Haftschicht-Deposition,
- Aufbringen des Handlingsubstrats und
- rückseitigem Dünnen (Si-Dünnen, Ätzstopp: SiO₂),
und das Bottomsubstrat nach
- Passivierung der Oberfläche und
- Klebeschicht-Deposition;

Figur 1d das Top- und Bottomsubstrat (den fertigen Stack) nach
- justiertem Zusammenfügen (Kleben),
- Entfernen des Handlingsubstrats,
- Entfernen der Haftschicht,
- Ätzen der Oxid- und Klebeschicht und
- Ätzen der Schutzschicht;

Figur 1e den Stack nach
- Entfernen des TiN und
- Ozon-TEOS-Deposition;

Figur 1f den Stack nach
- Oxid-Spacer-Ätzen,
- Fototechnik "Pad",
- Oxid-Ätzen,
- Lackentfernen und
- Reinigung;

Figur 1g den Stack nach
- TiN-Deposition,
- W-Deposition,
- Fototechnik "Nailhead",
- W-Ätzen und
- TiN-Ätzen/Lackveraschen;
- Figur 2: schematisch die gegenseitige Justage von Top- und Bottomsubstrat mit Hilfe einer Splitoptik.

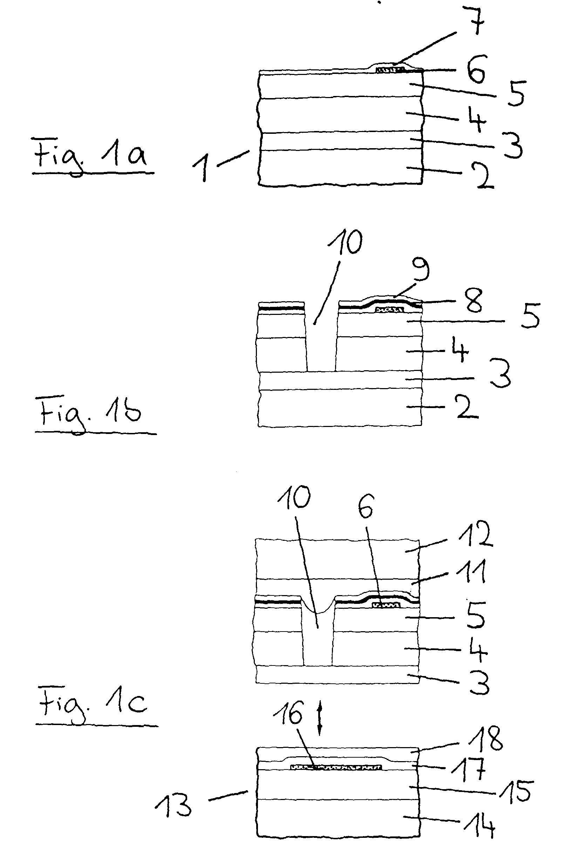

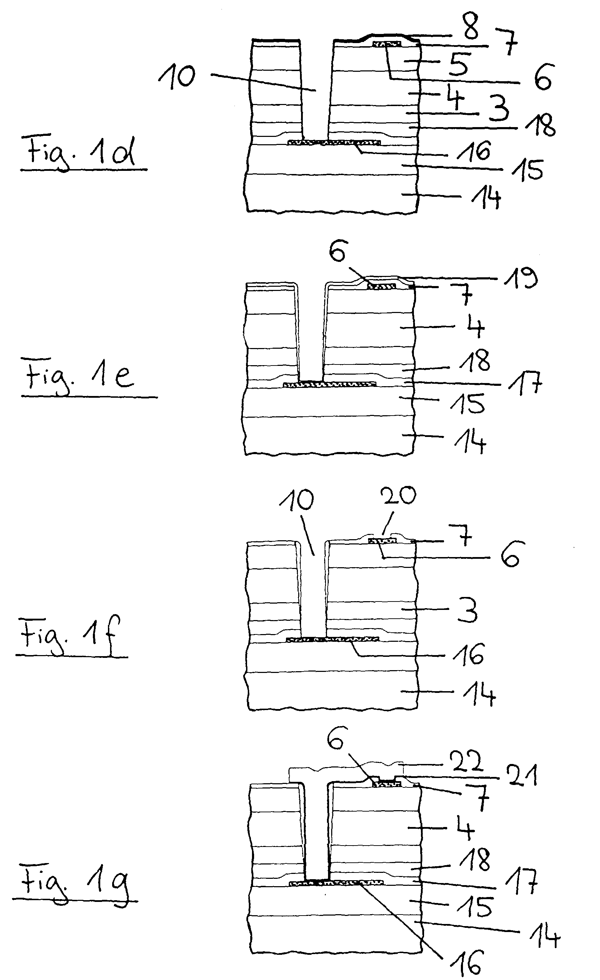

Das Topsubstrat 1 ist in diesem Beispiel eine SOI-Scheibe (2: Silizium; 3: Siliziumdioxid; 4: Silizium) mit fertigprozessierten MOS-Schaltungen in der Chipebene 5 und Dreilagenmetallisierung, passiviert mit einer Oxid/Nitrid-Schutzschicht 7, wie in Fig. 1a gezeigt. Die Metallisierung 6 der obersten Metallisierungsebene ist z.B. eine Aluminiumlegierung. Unterhalb der Metallisierungsebene befinden sich undotierte und dotierte Oxidschichten. Als Maskierungslagen für später folgendes Trockenätzen wird zunächst Titannitrid 8 und eine als Hardmaske dienende Schicht wie z.B. Plasmaoxid 9 abgeschieden und eine Fototechnik für die Vialöcher 10 durchgeführt (Fototechnik "Trench"). Mit Hilfe einer Lackmaske werden das Plasmaoxid 9 und das Titannitrid 8 sowie darunterliegenden Oxidschichten der Chipebene 5 anisotrop geätzt. Nach dem Lackentfernen wird im sogenannten Trenchätzverfahren bis zur Oberfläche des vergrabenen Oxids 3 geätzt (SiO₂ als Ätzstopp). Das Ergebnis ist in Fig. 1b dargestellt. Auf die Topscheibe 1 wird nun mittels einer organischen Haftschicht 11 eine Siliziumscheibe 12 als Handlingsubstrat geklebt und nachfolgend das Topsubstrat 1 von der Rückseite mechanisch und naßchemisch gedünnt. Als Ätzstopp dient hier die Unterfläche des vergrabenen Oxids 3 (SiO₂).

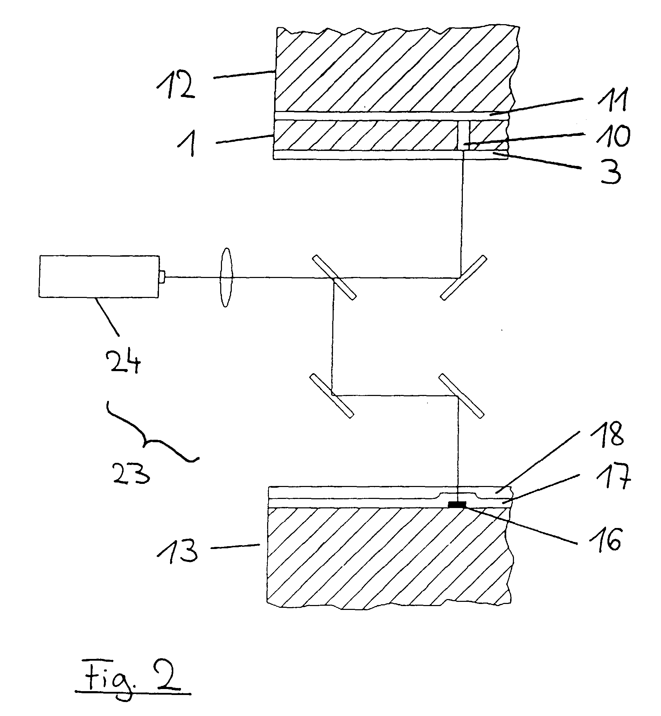

Auf die Bottomscheibe 13 (14: Silizium) mit fertigprozessierten MOS-Schaltungen in der Chipebene Bottom 15, Dreilagenmetallisierung (Metallisierung 16) und Passivierung 17 wird eine Polyimidschicht 18 als Inter-Chip-Kleber aufgeschleudert, so daß die Oberflächentopographie eingeebnet wird. Dann erfolgt das Kleben von Top- 1 und Bottomsubstrat 13 in einem Scheibenbondgerät mit Splitoptik (vgl. Fig. 1c). Die Splitoptik 23, die die Kamera 24 enthält, ist schematisch in Fig. 2 dargestellt.
Nach dem Entfernen des Handlingsubstrates 12 und der Haftschicht 11 kann nun die so entstandene Stackscheibe wie eine Standardsiliziumscheibe weiter prozessiert werden. Das vergrabene Oxid 3, die Klebeschicht 18 und die Schutzschicht 17 über dem Metall 16 der Bottommetallisierung werden in den Vialöchern 10 anisotrop geätzt. Als Ätzstopp dient hierbei die Metallisierung 16 (Fig. 1d).
Die Titannitridschicht 8, die als Maskierung für den Trockenätzprozeß diente, wird nun entfernt und Ozon-TEOS-Oxid 19 abgeschieden. Letzteres gewährleistet wegen seiner hohen Konformität bei der Deposition die elektrische Isolierung der Metallisierung der Vialöcher zum Siliziumsubstrat bei dem vorliegenden hohen Aspektverhältnis der Vialöcher (Fig. 1e).
Mittels eines stark gerichteten Trockenätzverfahrens wird anschließend eine Seitenwandpassivierung realisiert (sog. Spacer-Ätzverfahren mit Metallisierung 16 als Ätzstopp). Nach dem Öffnen der Kontaktlöcher 20 zur Topmetallisierung 6 mittels der Fototechnik "Pad", Oxid-Ätzen (Ätzstopp: Metallisierung 6), Lackentfernen und Reinigung (Fig. 1f) wird zunächst eine Titannitridschicht 21 als Haftund Barriereschicht für die nachfolgende Wolframmetallisierung 22 (durch W-Abscheidung) der Inter-Chip-Vias 10 abgeschieden. Mit Hilfe einer letzten Fototechnik "Nailhead" wird die Wolfram/Titannitridschicht 21, 22 strukturiert (W-Ätzen, TiN-Ätzen/Lackveraschen), so daß die vertikale Verbindung zwischen Top- und Bottombauelementen realisiert ist (Fig. 1g).

## Patentansprüche

1. Verfahren zur Herstellung einer vertikalen integrierten Schaltungsstruktur mit folgenden Verfahrensschritten:
- Bereitstellen eines ersten Substrates (1), das im Bereich einer ersten Hauptfläche eine oder mehrere erste Lagen (5) mit Schaltungsstrukturen und zumindest eine erste Metallisierungsebene (6) enthält;
- Aufbringen einer Schicht, die als Maske (8) für späteres Ätzen von dielektrischen Schichten dient, auf die Seite der ersten Hauptfläche des ersten Substrates;
- Öffnen von Vialöchern (10) in einem ersten Schritt im Bereich der ersten Hauptfläche des ersten Substrates, wobei die Vialöcher die Maske (8) und sämtliche erste Lagen mit Schaltungsstrukturen durchdringen;
- Verbinden des ersten Substrates (1) mit einem Hilfssubstrat (12) auf der Seite der ersten Hauptfläche;
- Dünnen des ersten Substrates (1) auf der Seite, die der ersten Hauptfläche gegenüberliegt;
- Bereitstellen eines zweiten Substrates (13), das im Bereich einer zweiten Hauptfläche zumindest eine zweite Lage (15) mit Schaltungsstrukturen und zumindest eine zweite Metallisierungsebene (16) enthält;
- Verbinden des ersten Substrates (1) mit dem zweiten Substrat (13), wobei die Seite des ersten Substrates, die der ersten Hauptfläche gegenüberliegt, und die Seite der zweiten Hauptfläche des zweiten Substrates justiert zusammengeführt werden;
- Entfernen des Hilfssubstrates (12);
- Öffnen der vorhandenen Vialöcher (10) in einem zweiten Schritt bis zur zweiten Metallisierungsebene (16) des zweiten Substrates (13), wobei die Maske (8) des ersten Substrates als Ätzmaske dient;
- Herstellen einer elektrisch leitfähigen Verbindung zwischen der ersten (6) und der zweiten Metallisierungsebene (16) über die Vialöcher (10).

2. Verfahren nach Anspruch 1,
**dadurch gekennzeichnet,**
daß
- vor dem Verbinden des ersten Substrates (1) mit einem Hilfssubstrat (12) im Bereich der ersten Hauptfläche des ersten Substrates erste Justiermarken erzeugt werden, die die ersten Lagen der Schaltungsstrukturen durchdringen,
- das zweite Substrat (13) im Bereich der zweiten Hauptfläche zweite Justiermarken enthält, und
- das justierte Zusammenführen des ersten und zweiten Substrates mittels einer Split-Optik (23) im sichtbaren Spektralbereich anhand der Justiermarken erfolgt.

3. Verfahren nach Anspruch 2,
**dadurch gekennzeichnet,**
daß die ersten Justiermarken durch die ersten Lagen der Schaltungsstrukturen geätzt werden und die zweiten Justiermarken metallische Strukturen in der zweiten Metallisierungsebene sind.

4. Verfahren nach einem der Ansprüche 1 bis 3,
**dadurch gekennzeichnet,**
daß das Öffnen der Vialöcher durch Ätzen erfolgt.

5. Verfahren nach einem der Ansprüche 1 bis 4,
**dadurch gekennzeichnet,**
daß die Vialöcher im ersten Schritt bis einige Mikrometer unterhalb der ersten Lagen der Schaltungsstrukturen geöffnet werden, und das Dünnen des ersten Substrates bis an die Vialöcher erfolgt.

6. Verfahren nach einem der Ansprüche 1 bis 4,
**dadurch gekennzeichnet,**
daß bei Verwendung eines SOI-Substrates als erstes Substrat (1) die Vialöcher (10) im ersten Schritt bis an die Oxidschicht (3) des SOI-Substrates geöffnet werden, und das Dünnen des ersten Substrates bis an diese Oxidschicht erfolgt.

7. Verfahren nach einem der Ansprüche 1 bis 6,
**dadurch gekennzeichnet,**
daß das Dünnen des ersten Substrates mittels Ätzen und/oder Schleifen erfolgt.

8. Verfahren nach einem der Ansprüche 1 bis 7,
**dadurch gekennzeichnet,**
daß das Verbinden der Substrate mittels einer transparenten Haftschicht (18) erfolgt, die auf die zweite Hauptfläche des zweiten Substrates aufgebracht wird.

9. Verfahren nach einem der Ansprüche 1 bis 8,
**dadurch gekennzeichnet,**
daß das erste Substrat über eine Haftschicht (11) mit dem Hilfssubstrat (12) verbunden wird.

10. Verfahren nach Anspruch 8 oder 9,
**dadurch gekennzeichnet,**
daß eine passivierende und/oder planarisierende Haftschicht verwendet wird.

11. Verfahren nach einem der Ansprüche 1 bis 10,
**dadurch gekennzeichnet,**
daß die Herstellung einer elektrisch leitfähigen Verbindung zwischen der ersten und der zweiten Metallisierungsebene folgende Verfahrensschritte umfaßt:
- Öffnen von Kontaktlöchern (20) zu der ersten Metallisierungsebene (6) des ersten Substrates (1);
- Seitenwandisolierung der Vialöcher (10);
- Bedecken und Verbinden der Via- und Kontaktlöcher mit metallischem Material.

## Claims

1. A method of fabricating a vertical integrated circuit structure with the following method steps:
- preparing a first substrate (1) which has one or more first layers (5) with circuit structures and at least one first metallisation plane (6) in the region of a first main surface;
- applying a layer which serves as a mask (8) for later etching of dielectric layers, on the side of the first main surface of the first substrate;
- opening vias (10) in a first step in the region of the first main surface of the first substrate, wherein the vias penetrate the mask (8) and all first layers with circuit structures;
- attaching the first substrate (1) to an auxiliary substrate (12) on the side of the first main surface;
- thinning the first substrate (1) on the side opposite the first main surface;
- preparing a second substrate (13), which has at least one second layer (15) with circuit structures and at least one second metallisation plane (16) in the region of a second main surface;
- attaching the first substrate (1) to the second substrate (13), wherein the side of the first substrate which is opposite the first main surface and side of the second main surface of the second substrate are joined together in register;
- removing the auxiliary substrate (12);
- opening the existing vias (10) in a second step up to the second metallisation plane (16) of the second substrate (13), wherein the mask (8) of the first substrate serves as an etching mask;
- making an electrically conductive connection between the first (6) and the second metallisation plane (16) through the vias (10).

2. A method according to claim 1, characterized in that
- first registration marks are created in the region of the first main surface of the first substrate before attaching the first substrate (1) to an auxiliary substrate (12), which marks penetrate the first layers of the circuit structure,
- the second substrate (13) has second registration marks in the region of the second main surface, and
- the joining together of the first and second substrates in register is effected on the basis of the registration marks by means of split optics (23) in the visible spectral region.

3. A method according to claim 2, characterized in that the first registration marks are etched through the first layers of the circuit structures and the second registration marks are metallic structures in the second metallisation plane.

4. A method according to any of claims 1 to 3, characterized in that the opening of the vias is effected by etching.

5. A method according to any of claims 1 to 4, characterized in that the vias are opened in the first step to some micrometers below the first layers of the circuit structures and the thinning of the first substrate is effected up to the vias.

6. A method according to any of claims 1 to 4, characterized in that, when using an SOI - substrate as the first substrate (1), the vias (10) are opened up to the oxide layer (3) of the SOI substrate in the first step and the thinning of the first substrate is effected up to this oxide layer.

7. A method according to any of claims 1 to 6, characterized in that the thinning of the first substrate is effected by etching and/or grinding.

8. A method according to any of claims 1 to 7, characterized in that the attachment of the substrates is effected by means of a transparent adhesive layer (18), which is applied to the second main surface of the second substrate.

9. A method according to any of claims 1 to 8, characterized in that the first substrate is attached to the auxiliary substrate (12) through an adhesive layer (11).

10. A method according to claim 8 or 9, characterized in that a passivating and/or planarizing adhesive layer is used.

11. A method according to any of claims 1 to 10, characterized in that the production of an electrically conductive connection between the first and second metallisation planes comprises the following method steps:
- opening contact holes (20) to the first metallisation plane (6) of the first substrate (1);
- sidewall insulation of the vias (10);
- covering and connecting the vias and contact holes with metallic material.

## Revendications

1. Procédé de fabrication d'un circuit intégré vertical comprenant les étapes de procédé suivantes :
- on réalise un premier substrat (1) qui comporte dans la zone de sa première surface principale, une ou plusieurs premières couches (5) avec des structures de circuit et au moins un premier plan de métallisation (6),
- on applique une couche qui sert de masque (8) pour l'attaque chimique future des couches diélectriques, sur le côté de la première surface principale de ce substrat,
- on ouvre des trous traversants (10) au cours de la première étape, au niveau de la surface principale du premier substrat, les passages traversant le masque (8) et toutes les premières couches et structures de commutation ;
- on relie le premier substrat (1) à un substrat auxiliaire (12) du côté de la première surface principale,
- on amincit le premier substrat (1) du côté opposé à celui du passage principal,
- on fournit un second substrat (13) qui comporte au niveau de l'une des deux surfaces principales, au moins deux couches (51) avec des structures de circuit et au moins un second plan de métallisation (16) ;
- on relie le premier substrat (1) au second substrat (13) si le côté du premier substrat se trouve en regard de la première surface principale et si le côté de la seconde surface principale est réuni avec ajustage du second substrat,
- on enlève le substrat auxiliaire (12)
- on ouvre les trous traversants de ventilation prévus (10) dans une seconde étape, jusqu'au plan de métallisation complet (16) qui sert au second substrat (13), le masque (8) servant au premier substrat comme masque de corrosion,
- on réalise une liaison électrique entre le premier plan de métallisation (6) et le second plan de métallisation (16) par l'intermédiaire des trous traversants (10).

2. Procédé selon la revendication 1,
caractérisé en ce que
- avant de relier le premier substrat (1) à un substrat auxiliaire (12) au niveau de la première surface principale du premier substrat, on génère d'abord des repères d'ajustage qui traversent les positions des structures de commutation,
- le second substrat (13) comporte des seconds repères d'ajustage au niveau de la seconde surface principale, et
- la réunion ajustée du premier et du second substrat se fait chaque fois à l'aide d'une optique divisée (23) dans la plage spectrale visible.

3. Procédé selon la revendication 2,
caractérisé en ce que
les premiers repères d'ajustage sont attaqués chimiquement à travers les premières couches des structures de circuit, et les secondes structures métalliques d'ajustage sont dans le second plan de métallisation.

4. Procédé selon l'une quelconque des revendications 1 à 3,
caractérisé en ce que
l'ouvertures des trous traversants se fait par attaque chimique.

5. Procédé selon l'une quelconque des revendications 1 à 4,
caractérisé en ce que
les nombreux trous traversants sont réalisés au cours d'une première étape jusqu'à quelques microns en dessous de la première étape des structures simplifiées, et l'amincissement du premier substrat se poursuit jusqu'aux trous traversants.

6. Procédé selon l'une quelconque des revendications 1 à 4,
caractérisé en ce qu'
en utilisant un substrat (SOI) comme premier substrat (1), on ouvre les trous traversants (10) dans une première étape, jusqu'à la couche d'oxyde (3) du substrat (SOI), puis on amincit le premier substrat jusqu'à la couche d'oxyde.

7. Procédé selon l'une quelconque des revendications 1 à 6,
caractérisé en ce que
l'amincissement du second substrat se fait par attaque chimique et/ou par meulage.

8. Procédé selon l'une quelconque des revendications 1 à 7,
caractérisé en ce que
la liaison du substrat se fait à l'aide d'une couche d'accrochage transparente (18) appliquée sur la seconde surface principale du second substrat.

9. Procédé selon l'une quelconque des revendications 1 à 8,
caractérisé en ce que
le premier substrat est relié par une couche d'accrochage (11) au substrat auxiliaire (12).

10. Procédé selon l'une quelconque des revendications 8 ou 9,
caractérisé par
une couche d'accrochage passivée et/ou non passivée.

11. Procédé selon l'une quelconque des revendications 1 à 10,
caractérisé en ce que
la réalisation d'une liaison électrique entre le premier plan de métallisation et le second plan de métallisation comprend les étapes de procédé suivantes :
- on ouvre les trous de contact (20) vers le premier plan de métallisation (6) du premier substrat (1)
- on isole les parois latérales des passages de viabilisation (9)
- on recouvre et on définit les orifices de liaison et contact avec de la matière métallique.
